Europäisches Patentamt

European Patent Office

Office européen des brevets

(11) Numéro de publication: **0 191 255**
**B1**

(12) **FASCICULE DE BREVET EUROPEEN**

(45) Date de publication du fascicule du brevet:
27.09.89

(21) Numéro de dépôt: **85402433.8**

(22) Date de dépôt: **06.12.85**

(51) Int. Cl.⁴: **H 01 L 29/747, H 01 L 29/743**

(54) Structure intégrée de triac à commande par diac.

(30) Priorité: **11.12.84 FR 8418925**

(43) Date de publication de la demande:
**20.08.86 Bulletin 86/34**

(45) Mention de la délivrance du brevet:
**27.09.89 Bulletin 89/39**

(84) Etats contractants désignés:
**CH DE FR GB IT LI NL**

(56) Documents cités:
**EP-A- 186 567**
**WO-A-83/00582**
**FR-A- 2 253 285**
**FR-A- 2 279 224**
**US-A- 3 524 114**
**US-A- 4 054 893**
**US-A- 4 216 488**

**R. Müller:"Bauelemente der Halbleiterelektronik",**
**Springer Verlag, 1979**

(73) Titulaire: **THOMSON-CSF, 51, Esplanade du Général de Gaulle, F-92800 Puteaux (FR)**

(72) Inventeur: **Noguier, Jean-Pierre, THOMSON-CSF SCPI 173, bld. Haussmann, F-75379 Paris Cedex 08 (FR)**
Inventeur: **Montaut, Jean-Paul, THOMSON-CSF SCPI 173, bld. Haussmann, F-75379 Paris Cedex 08 (FR)**

(74) Mandataire: **Rinuy, Santarelli, 14, avenue de la Grande Armée, F-75017 Paris (FR)**

## Description

L'invention concerne les composants semiconducteurs de commutation de puissance et plus particulièrement les triacs.

Dans beaucoup d'applications, on souhaite commander les triacs par l'intermédiaire d'un diac placé en amont de la gâchette du triac. Un diac est un composant à deux bornes un peu analogue à un ensemble de deux diodes tête-bêche en série, ou encore à un transistor dont la base serait déconnectée et non accessible, et il présente une caractéristique tension-courant avec un seuil très franc (coude à angle aigu dans la caractéristique) entre une région de blocage pour des tensions inférieures en valeur absolue à une tension de seuil Vd, et une région de conduction. Le seuil est très franc parce que la caractéristique tension-courant présente une portion à résistance dynamique négative immédiatement au delà du seuil.

Par exemple, on commande souvent un triac par l'intermédiaire d'un diac pour réaliser des variateurs de puissance ou des gradateurs de lumière.

Dans une autre application imaginée par la demanderesse, on connecte un diac entre la gâchette et l'anode d'un triac (triac à gâchette de cathode), pour aboutir à un composant à deux bornes seulement (anode et cathode du triac) susceptible d'être connecté comme élément de protection contre les surtensions entre deux bornes d'un circuit à protéger.

Devant ce besoin, on s'est préoccupé de réaliser le diac et le triac sur un même substrat semiconducteur. Mais l'intégration de ces deux éléments pose des problèmes. En effet, un triac est constitué par une structure à quatre couches superposées NPNP ou PNPN, tandis qu'un diac est réalisé par une structure à trois couches superposées PNP ou NPN. L'intégration devrait donc consister à utiliser pour le diac trois couches parmi les quatre prévues pour le triac.

Malheureusement, ceci s'avère très difficile car cela suppose que la couche principale constituant le substrat semiconducteur forme alors une couche active à la fois pour le diac et pour le triac. Il faudrait donc isoler deux parties différentes de la couche principale, l'une pour le diac, l'autre pour le triac, ce qui n'est pas possible.

D'autres contraintes électriques ou technologiques rendent très difficile une intégration d'un triac et d'un diac; notamment il est difficile de prévoir des dopages et épaisseurs de couches qui soient compatibles pour la structure tricouche du diac et la structure quadricouche du triac.

La présente invention selon la revendication 1 propose une solution inattendue consistant à réaliser le diac non pas sous forme d'une structure à trois couches superposées comme cela a toujours été fait pour des diacs, mais sous forme d'une structure latérale dans laquelle deux régions superficielles métallisées de même type de conductivité sont formées sur une même face du substrat et sont séparées l'une de l'autre en restant adjacentes à une même région de type opposé située au-dessous des deux premières. La face du substrat que l'on utilise est celle qui comporte une métallisation de gâchette pour le triac.

De préférence, dans la zone de diac, l'autre face du substrat est creusée et isolée pour que le substrat ne comporte pas dans cette zone plus de trois couches superposées de conductivités alternées.

D'autres caractéristiques et avantages de l'invention apparaîtront à la lecture de la description détaillée qui suit et qui est faite en référence aux dessins annexés dans lesquels:

– la figure 1 représente en coupe transversale la structure de composant selon l'invention,

– les figures 2a et 2b représentent à échelle réduite des vues de dessus de composant,

– les figures 3a et 3b représentent des vues de dessous,

– les figures 4 à 12 représentent les étapes d'un procédé de fabrication du composant,

– les figures 13 à 16 représentent diverses étapes d'une variante de procédé de fabrication du composant.

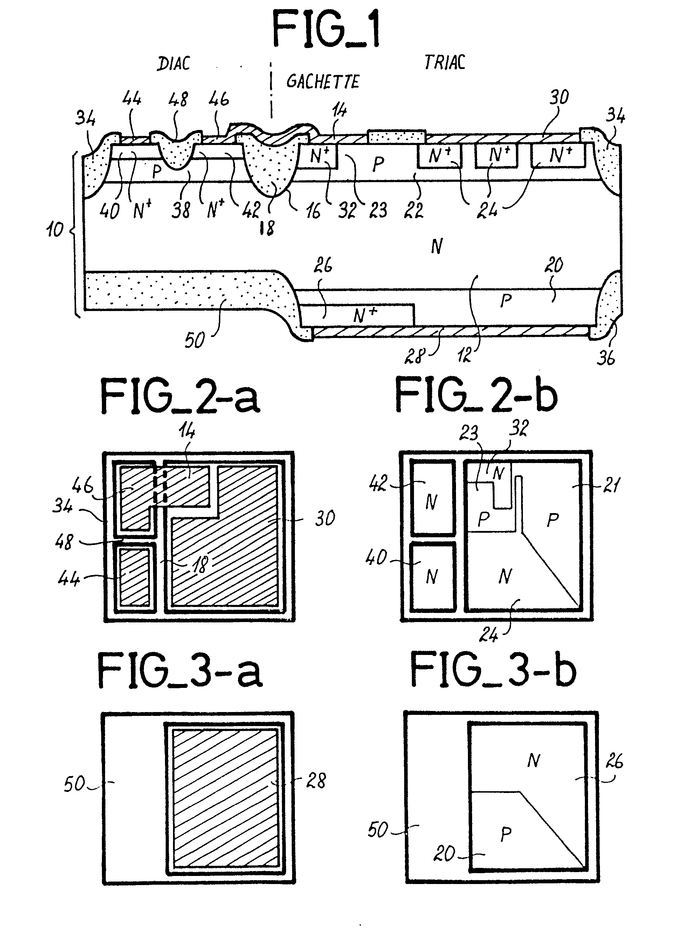

Le composant selon l'invention est représenté sous une forme préférentielle à la figure 1.

Il est réalisé sur un substrat semiconducteur unique 10, découpé par exemple selon une forme rectangulaire comme on pourra le voir sur les diverses vues de dessus représentées.

Dans l'exemple choisi le substrat de départ est de type N. Une couche centrale 12 de type N constitue donc l'essentiel de l'épaisseur du substrat.

La pastille semiconductrice constituant le composant est divisée en deux zones, respectivement une zone pour le diac sur la gauche de la figure, et une zone pour le triac sur la droite de la figure. La zone de triac occupe une surface beaucoup plus importante car elle doit laisser passer le courant principal à travers le composant, le diac n'ayant qu'à assurer la transmission d'un courant de déclenchement pour le triac.

Le triac est constitué d'une manière tout à fait classique et, si l'on découpait fictivement le substrat pour en séparer la zone de diac, on retrouverait un triac ne présentant avec un triac classique qu'une seule différence: le fait que la métallisation de gâchette 14 du triac s'étend au-dessus d'un sillon 16 creusé dans le silicium et rempli d'une couche de passivation 18; dans un triac classique, la métallisation de gâchette s'arrêterait au bord du sillon passivé qui entoure généralement la pastille constituant le triac.

Sans rentrer dans les détails de la constitution classique de ce triac, on précise ici qu'il comporte deux thyristors tête-bêche en parallèle dont l'un est pourvu d'une gâchette métallisée (métallisation 14). Une région P 20 constitue l'anode de l'un des thyristors et la région de gâchette (sans métallisation) de l'autre. Une région P 22, divisée en une portion 21 et une portion 23 constitue l'anode de l'autre thyristor (portion 21) et la région de gâchette métallisée du premier (portion 23); sur la figure 1, seule la portion 23 est véritablement visible compte tenu du plan de coupe utilisé pour cette figure; la différence entre les régions 21 et 23 est visible à la figure 2b; Les régions P 20 et 22 sont situées de part et d'autre de la région N 12; une région N 24 interrompue localement par des trous de court-circuit constitue la cathode du premier thyristor, et une région N 26 constitue l'anode du second. Une première métallisation principale 28 recouvre les regions 20 et 26 sur la face arrière de la pastille. Une deuxième métallisation principale 30 recouvre les régions 22 et 24 sur la face avant du thyristor, c'est-à-dire sur la face qui comprend aussi la métallisation de gâchette 14. Enfin, il faut préciser que la métallisation de gâchette recouvre non seulement la portion 23 de la couche 22 de type P, mais aussi une portion de couche 32 de type N, pour l'amorçage du triac lorsque le potentiel sur la métallisation de gâchette est négatif par rapport au potentiel sur la deuxième métallisation principale 30 (amorçage dit dans les deuxième et troisième quadrants).

Enfin, on a désigné par les références 34 et 36 les sillons passivés qui entourent toute la pastille (diac + triac) sur la face supérieure et la face inférieure de celle-ci.

Le diac, situé sur la partie gauche de la figure 1, est constitué à l'aide de trois couches de conductivités alternées. Dans l'exemple choisi il s'agit d'une alternance NPN et la région centrale de type P est constituée par une région 38 diffusée exactement de la même manière et en même temps que la région 22 constituant la gâchette du triac.

Mais à la différence des diacs connus, celui-ci n'est pas constitué par une superposition de trois couches alternées. Au contraire, il a une structure latérale; une région 40 de type N$^+$ est diffusée sur une partie de la profondeur de la région 38 et une région 42 de type N$^+$ est diffusée dans une autre partie.

Les deux régions 40 et 42 sont séparées l'une de l'autre et chacune est métallisée. La métallisation 44 recouvrant la région 40 sert de borne de connexion pour la commande de l'ensemble du composant. La métallisation 46 recouvrant la région 42 est reliée directement à la métallisation de gâchette 14 du triac, par dessus le sillon passivé 16 creusé dans le silicium sur une profondeur supérieure à la profondeur des régions 22 et 38 (ce sillon isole le diac du triac).

Dans l'exemple représenté à la figure 1, les régions N 40 et 42 sont séparées par un sillon isolé 48, de profondeur inférieure à celle de la région 38. Le diac fonctionne de la manière suivante: lorsque la tension entre ses bornes (métallisations 44 et 46) dépasse un seuil de quelques dizaines de volts, variable selon le profil de dopage de la région 38 et selon la profondeur de diffusion des région 40 et 42, le transistor à base ouverte constitué par les régions 40, 38, 42, passe en régime de conduction brutale et fait passer un courant vers la métallisation de gâchette 14, déclenchant la conduction du triac. Le déclenchement se produit par suite de la mise en avalanche de la jonction entre les régions 38 et 40 ou 38 et 42 là où cette jonction rencontre le sillon passivé 48.

De préférence, comme on le voit sur la figure 1, la zone de diac ne comporte pas une superposition de plus de trois couches de conductivité alternées (ici, couches 40, 38, 12 NPN).

En effet, une quatrième couche telle que la région 20 pourrait, si on la trouvait au-dessous du diac, contribuer à la constitution d'un thyristor parasite indésirable.

C'est pourquoi, à la figure 1, on a représenté le substrat creusé et passivé par une couche de verre 50 sous toute la zone de diac du côté de la face arrière du substrat. La profondeur du sillon est supérieure à la profondeur de la région 20 de type P.

Dans ces conditions, le dopage de la région 20 peut se faire sans masquage sur toute la face arrière de substrat et on enlèvera ensuite le silicium par attaque chimique sélective au-dessous du diac.

La figure 2 représente à échelle réduite en a) une vue de dessus du composant. On a figuré en trait plein épais le pourtour des sillons passivés et en traits hachurés entourés d'un trait moins épais les métallisations; en b), on a représenté les formes des zones diffusées N et P affleurant à la surface supérieure du substrat entre les sillons passivés, les métallisations étant supposées enlevées pour permettre l'observation de régions N et P. On retrouve sur la partie gauche des figures le diac et sur la partie droite le triac. Les vues de dessus du triac sont identiques à celles d'un triac classique à l'exception du fait que la métallisation de gâchette 14 est reliée directement, par dessus le sillon passivé 18, à l'une des métallisations (46) du diac à structure latérale.

La figure 3 représente à la même échelle réduite la vue de dessous du composant; en a) on voit la métallisation unique de face arrière; en b) on voit la forme classique des régions N et P affleurant sur la face arrière. Sur la partie gauche de la figure, seul est visible le sillon passivé 50 sous la totalité de la zone de diac.

Les trous de court-circuit n'ont pas été représentés sur ces figures.

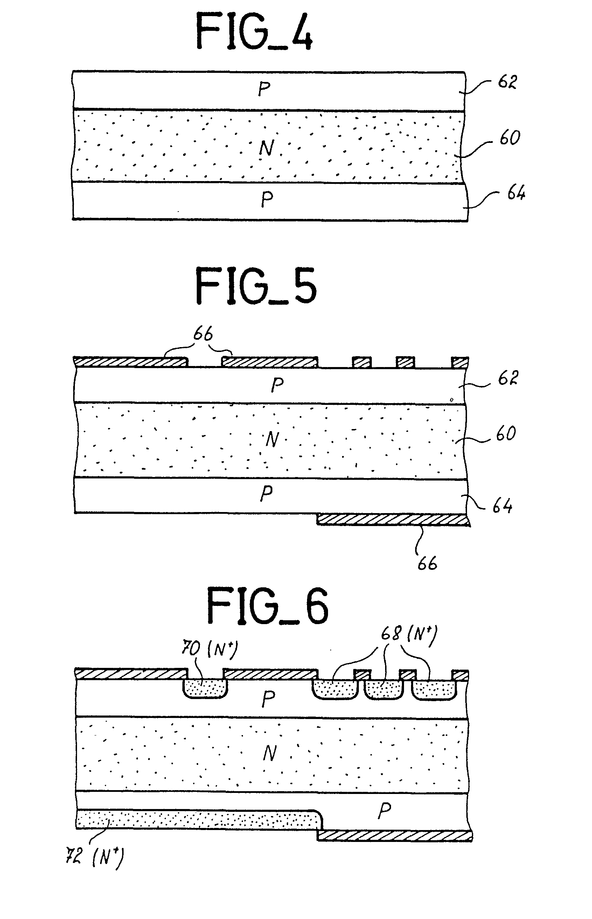

Les figures 4 à 12 représentent les diverses étapes d'un procédé de fabrication selon l'invention.

On part d'un substrat semiconducteur 60 d'un premier type de conductivité (ici: N). On effectue une diffusion non localisée, sur les deux faces, d'une impureté de type opposé (P) pour former deux couches 62 et 64 dont le profil de diffusion varie de préférence en diminuant de la surface vers l'intérieur du substrat (figure 4). C'est ce profil variable qui permet ensuite l'ajustement de la tension de déclenchement du composant par simple ajustement de la profondeur de diffusion des régions 40, 42 de la figure 1.

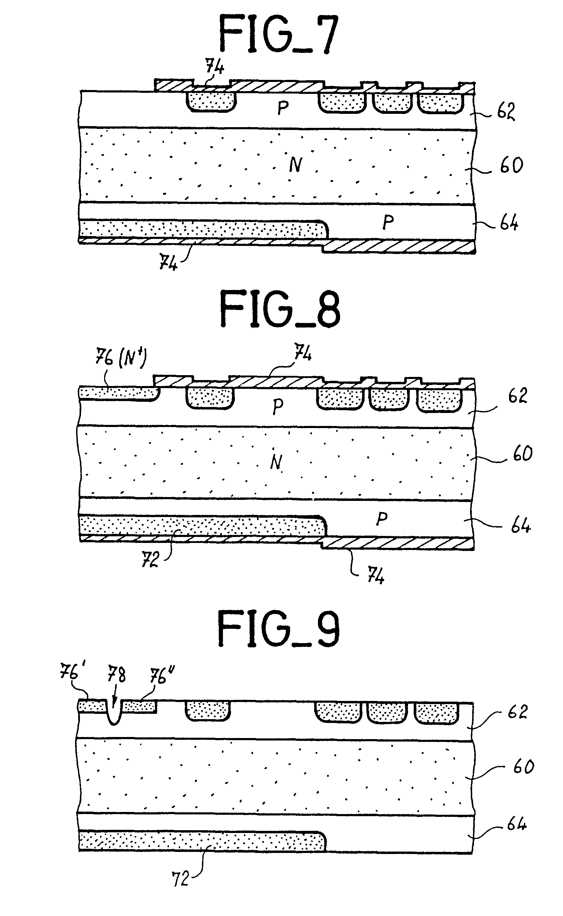

On oxyde les surfaces du substrat et on ouvre localement par photogravure l'oxyde 66 formé sur chacune des faces du substrats (figure 5).

On diffuse à travers les ouvertures de l'oxyde une impureté de type N, l'oxyde 66 empêchant la diffusion de cette impureté là où il est présent. On forme ainsi des régions de cathode 68 sur la face supérieure du substrat (correspondant aux régions 24 de la figure 1), une région 70 d'accès de type N à la région de gâchette (correspondant à la région 32 de la figure 1) sur la face supérieure également. Sur la face inférieure on forme par cette diffusion une région 72 de cathode, correspondant à la région 26 de la figure 1. Les diffusions de type N s'étendent seulement sur une partie de la profondeur des régions P 62 et 64 (figure 6).

On oxyde à nouveau les surfaces de substrat (couche d'oxyde 74), et on ouvre localement l'oxyde sur la face supérieure du substrat dans la région du diac (partie gauche de la figure 7).

On diffuse une impureté de type N dans le substrat, l'oxyde jouant le rôle de masque de diffusion. La profondeur de la région 76 ainsi diffusée est inférieure à celle de la région P 62; elle est choisie en fonction du profil de dopage de cette région P 62 de manière que le claquage de la jonction entre les régions 76 et 62 se produise pour une valeur de tension choisie (de l'ordre de quelques dizaines de volts par exemple); comme la concentration en impuretés de type P va en décroissant à mesure qu'on descend dans la couche P 62, la tension de claquage augmente si la profondeur de la région 76 augmente (figure 8).

On élimine alors l'oxyde subsistant sur les faces du substrat; par photogravure on creuse un sillon 78 dans la face supérieure du substrat pour séparer la région 76 de type N⁺ en deux régions 76' et 76'' correspondant respectivement aux régions 40 et 42 de la figure 1. Ce sillon s'étend plus profondément que la région 76 mais moins profondément que la région 62. Les régions 76' et 76'' restent donc adjacentes à une portion commune de la couche 62 (figure 9).

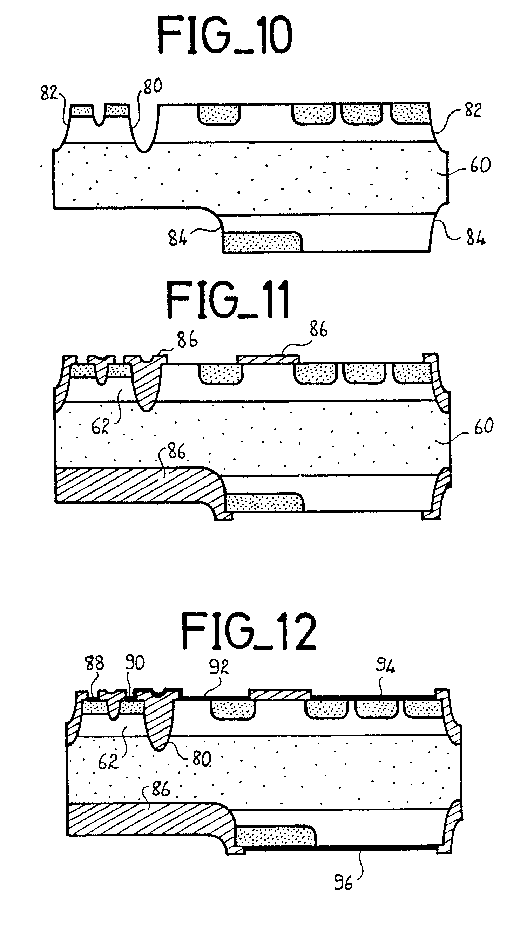

Toujours par photogravure, on creuse des sillons profonds dans le silicium sur ses deux faces. Un sillon 80 sépare la région du diac de celle du triac (il correspond au sillon 16 de la figure 1). Un sillon périphérique 82 est creusé sur la face supérieure sur tout le pourtour de la pastille constituant le composant (diac + triac). Un sillon 84 est creusé sur l'autre face, sur le pourtour de la pastille. De plus, le sillon 84 est creusé également sous toute la zone correspondant au diac. Tous ces sillons sont creusés à la même profondeur, supérieure à la profondeur des régions P 62 et 64; ils pénètrent donc dans la région centrale N constituant le corps principal du substrat 60 (figure 10).

On recouvre alors les deux faces du substrat d'un verre de passivation 86 qui remplit les sillons, puis on grave ce verre pour dénuder le silicium là où on doit effectuer des métallisations (figure 11).

On métallise les deux faces du substrat, par exemple par pulvérisation puis gravure d'aluminium, pour former deux électrodes de diac 88 et 90, une électrode de gâchette de triac (92), et deux électrodes principales de triac (94 et 96), respectivement sur la face supérieure et la face inférieure du substrat.

On notera qu'on laisse subsister du métal au-dessus du sillon 80 pour relier directement une électrode de diac (90) à l'électrode de gâchette (92) du triac (figure 12). La portion de région 62 située dans la zone du diac est isolée de toute métallisation.

Le montage de ce composant dans un boîtier peut se faire de la même manière que pour un triac; la seule différence est que la borne de connexion extérieure prévue pour la commande du triac sera reliée à la métallisation 88 du diac et non à la métallisation de gâchette du triac.

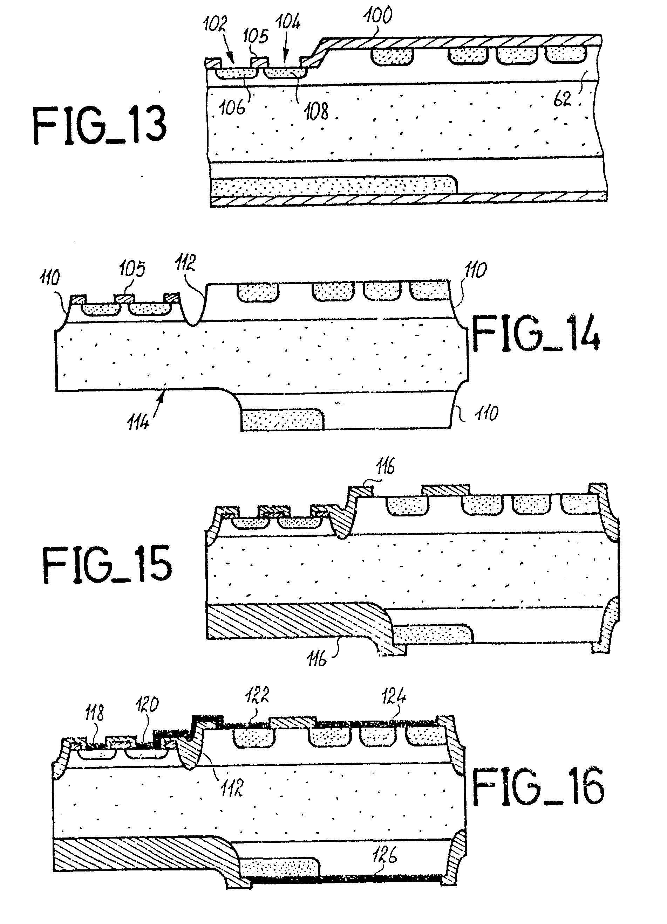

Les figures 13 à 16 représentent les étapes d'une variante de procédé de réalisation aboutissant à une structure légèrement différente de celle de la figure 1.

Si on repart de la figure 7, c'est-à-dire après réoxydation et ouverture de l'oxyde 74 de la face supérieure dans la région du diac, on attaque le silicium non recouvert d'oxyde pour le creuser jusqu'à une profondeur telle que le diac une fois terminé ait une tension de seuil bien déterminée.

On oxyde à nouveau le silicium après creusement, et on ouvre la couche d'oxyde 100 ainsi formée, dans deux régions 102 et 104 correspondant aux deux électrodes du diac.

On diffuse alors une impureté de type N pour former des régions 106 et 108 qui s'étendent sur une partie seulement de la profondeur de la région P 62 (profondeur qui est réduite dans la région du diac). Les régions 106 et 108 sont séparées l'une de l'autre par une portion de région P recouverte d'oxyde de silicium 105. Cet oxyde 105 protège les remontées de jonction N/P affleurant à la surface du substrat (figure 13). La tension de seuil du diac est liée au claquage de la jonction entre la région 62 et les régions 106 et 108. Le claquage dépend du dopage de la région 62 (moins dopée que les régions 106 et 108) dans la zone de courbure de la jonction. C'est pourquoi on ajuste la tension de seuil en creusant le silicium dans la région du diac (opération faite à la figure 13) jusqu'à une profondeur telle que le dopage superficiel de la région 62 corresponde à la tension de seuil désirée.

On élimine ensuite l'oxyde recouvrant la zone correspondant au triac, en conservant l'oxyde sur la face supérieure du substrat dans la zone correspondant au diac; puis, on creuse les mêmes sillons qui ont été mentionnés en référence à la figure 10 (sillons périphériques 110, sillon de séparation entre diac et triac 112, sillon sous la totalité du diac 114, figure 14).

On recouvre le substrat de verre de passivation 116 sur ses deux faces. Le verre remplit aussi les sillons. On grave le verre là où on veut réaliser des métallisations, de la même manière qu'à la figure 11 (figure 15); on dépose et on grave de l'aluminium (figure 16) pour réaliser deux métallisations de diac (118 et 120), une métallisation de gâchette 122 du triac, une métallisation d'électrode principale de triac (124) le tout sur la face supérieure du substrat, les métallisations 120 et 122 étant directement reliées au-dessus du sillon passivé 112. Une métallisation 126 d'électrode principale du triac est prévue d'autre part sur la face inférieure du substrat. La portion de région 62 située dans la zone du diac est isolée de toute métallisation.

Le composant selon l'invention est particulièrement adapté à la réalisation d'un élément de protection à deux bornes, destiné à assurer la protection d'un circuit contre les surtensions: dans ce cas, lors de l'encapsulation, la métallisation d'accès au diac (celle qui n'est pas reliée à la gâchette du triac) est reliée, par exemple par une barette conductrice ou un fil d'aluminium à la broche de connexion reliée à la face arrière du substrat. Les deux seules bornes extérieures de ce composant de protection sont donc reliées aux métallisations 28 et 30 de la figure 1.

**Revendications**

1. Composant semiconducteur intégré comprenant un triac dont la gâchette est reliée à un diac, caractérisé en ce que le diac est formé sur le même substrat que le triac et est réalisé par une structure comprenant essentiellement deux régions (40, 42) d'un premier type de conductivité séparées l'une de l'autre et formées sur une face du substrat, ces régions étant recouvertes par des métallisations séparées (44, 46), et une région de type opposé (38), isolée de toute métallisation, adjacente aux deux premières régions (40, 42), l'une des métallisations (46) étant par ailleurs reliée à une métallisation de gâchette du triac sur la même face du substrat, cette gâchette étant dudit type de conductivité opposé, et l'autre métallisation (44) servant de borne de commande pour le composant.

2. Composant selon la revendication 1, caractérisé en ce que le premier type de conductivité est le type N⁺.

3. Composant selon la revendication 1, caractérisé en ce que l'autre face du substrat est creusée d'un sillon passivé (50) sous le diac.

4. Composant selon la revendication 1, caractérisé en ce que la région de type opposé (38) du diac est constituée par la même couche semiconductrice (22) que la région de gâchette métallisée (23) du triac.

5. Composant selon la revendication 1, caractérisé en ce que le diac est séparé latéralement du triac par un sillon passivé (16) plus profond que la région de gâchette métallisée (23) du triac.

**Patentansprüche**

1. Integriertes Halbleiter-Bauelement, das einen Triac umfasst, dessen Trigger mit einem Diac verbunden ist, dadurch gekennzeichnet, dass der Diac auf demselben Substrat wie der Triac ausgebildet und durch eine Struktur verwirklicht ist, die im wesentlichen folgende Bereiche umfasst: zwei Bereiche (40, 42) eines ersten Leitungstyps, die voneinander getrennt und an einer Oberfläche des Substrates ausgebildet sind, wobei diese Bereiche durch getrennte Metallisierungen (44, 46) bedeckt sind, und einen Bereich (38) vom entgegengesetzten Leitungstyp, der von jeder Metallisierung isoliert und zu den beiden ersten Bereichen (40, 42) benachbart ist, wobei die eine der Metallisierungen (46) im übrigen mit einer Triggermetallisierung des Triacs auf derselben Oberfläche des Substrates verbunden ist und dieser Trigger vom besagten entgegengesetzten Leitungstyp ist, während die andere Metallisierung (44) als Steueranschluss für das Bauelement dient.

2. Bauelement nach Anspruch 1, dadurch gekennzeichnet, dass der erste Leitungstyp der N⁺ Typ ist.

3. Bauelement nach Anspruch 1, dadurch gekennzeichnet, dass auf der anderen Seite des Substrates unter dem Diac ein passivierter Streifen (50) vertieft angeordnet ist.

4. Bauelement nach Anspruch 1, dadurch gekennzeichnet, dass der Bereich (38) vom entgegengesetzten Leitungstyp des Diac von derselben halbleitenden Schicht (22) gebildet wird, wie der metallisierte Triggerbereich (23) des Triacs.

5. Bauelement nach Anspruch 1, dadurch gekennzeichnet, dass der Diac seitlich vom Triac durch einen passivierten Streifen (16) getrennt ist, der tiefer ist als der metallisierte Triggerbereich (23) des Triacs.

**Claims**

1. An integrated semiconductor component comprising a triac the gate of which is connected to a diac, characterized in that the diac is formed on the same substrate as the triac and is formed by a structure essentially comprising two regions (40, 42) of a first type of conductivity, separated from one another and formed on one face of the substrate, these regions being covered by separate metallizations (44, 46), and a region of the opposite type (38), isolated from any metallization, adjacent to the two first regions (40, 42), one of the metallizations (46) also being connected to a metallization of the gate of the triac on the same face of the substrate, this gate being of the said type of opposite conductivity, and the other metallization (44) acting as a control terminal of the component.

2. A component according to Claim 1, characterized in that the first type of conductivity is type N⁺.

3. A component according to Claim 1, characterized in that the other face of the substrate is hollowed out by means of a passivated groove (50) below the diac.

4. A component according to Claim 1, characterized in that the region of opposite type (38) of the diac is constituted by the same semiconducting layer (22) as the metallized gate region (23) of the triac.

5. A component according to Claim 1, characterized in that the diac is laterally separated from the triac by a passivated groove (16) which is deeper than the metallized gate region (23) of the triac.

1/5

# FIG_1

# FIG_2-a

# FIG_2-b

# FIG_3-a

# FIG_3-b

2/5

# FIG_4

P — 62

N — 60

P — 64

# FIG_5

66

P — 62

N — 60

P — 64

66

# FIG_6

70 (N⁺)   68 (N⁺)

P

N

P

72 (N⁺)

# FIG_7

# FIG_8

# FIG_9

4 / 5

# FIG_10

# FIG_11

# FIG_12

**FIG_13**

102   105   104   100

106   108   62

**FIG_14**

110   105   112   110

114   110

**FIG_15**

116

116

**FIG_16**

118   120   122   124

112   126